# EUROPEAN PATENT SPECIFICATION

(11) **EP 2 428 806 B1**
(45) Date of publication and mention of the grant of the patent: **10.04.2013**
(21) Application number: 11179041.6
(22) Date of filing: 26.08.2011
(51) Int. Cl.: G01R 31/28

(54) **Simulating an umbilical cable**
Simulierung eines Nabelschnurkabels
Simulation d'un câble ombilical

(30) Priority: 13.09.2010 EP 10176447
(43) Date of publication of application: 14.03.2012
(73) Proprietor: Vetco Gray Controls Limited, Bristol BS48 1BS (GB)
(72) Inventor: Puchianu, Silviu, Portishead, Bristol BS20 7AX (GB)
(74) Representative: Emerson, Peter James

(56) References cited:
- WO-A1-2009/026971
- WO-A1-2010/018544
- US-A1- 2009 185 609
- SRINIVASA RAO Y ET AL: "Rapid prototyping tool for electrical load emulation using power electronic converters", INDUSTRIAL ELECTRONICS&APPLICATIONS, 2009. ISIEA 2009. IEEE SYMPOSIUM ON, IEEE, PISCATAWAY, NJ, USA, 4 October 2009 (2009-10-04), pages 106-111, XP031582384, ISBN: 978-1-4244-4681-0

## Description

### Field of the Invention

This invention relates to a method of simulating an umbilical cable for use with a subsea fluid extraction well, a method of testing control equipment for a subsea fluid extraction well and apparatus for simulating an umbilical for use with a subsea fluid extraction well.

### Background of the Invention

With a subsea fluid extraction well, such a hydrocarbon extraction well, an umbilical cable which can be up to several tens of kilometres in length, is used to transfer communications (for control and monitoring), electrical power, hydraulics and chemicals between an above-surface well control station and subsea control equipment, located on the subsea, which is used to control well operation. The type and complexity of an umbilical cable depends on the number of wells being controlled and the scope of supply of the subsea control equipment. Umbilical cables are therefore designed specifically for each application. Due to the length and characteristics of an umbilical cable, it can cause detrimental effects to the signals and power being transmitted through it (such as loss of power, attenuation of signals and reflections which can cause overvoltages, etc). These aspects have to be taken into consideration in the design of the overall system.

When the subsea control equipment is brought together and assembled in its system configuration for testing prior to installation (such as at the factory or at a system test facility), there is a need to simulate the umbilical cable order to provide the signal and power characteristics expected at its termination when testing, because it is impracticable to utilise the actual umbilical cable itself.

The main electrical aspects of subsea control equipment which need testing are the electrical aspects, which include the control and distribution of electrical power to the various equipments which are to be installed on the seabed and the communication between surface equipment and subsea equipment. The method of communication usually employed is known as communications-on-power (COP), where the communication signals are superimposed on the electrical power supply. Any electrical effects caused by the use of a long umbilical cable due to its particular electrical characteristics need to be simulated to ensure that the electrical power applied to the subsea control equipment in its test configuration is the same as that when installed and operational on the seabed and the method and characteristics of the communications (for example, COP) are the same.

At present, the method of testing adopted is to use a hardware representation of the umbilical in the form of specially designed electrical circuitry (an arrangement of passive components) which is connected between the main electrical supply and the subsea control equipment under test. A new umbilical cable simulator has to be designed and built for each test configuration, which is expensive and time consuming.

WO 2010/18544 discloses a method of simulating a transmission line having the precharacterising features of claim 1.

As further background cable/transmission line simulating methodologies, there may be mentioned WO 2009/026971, US 2009/185609 and "Rapid prototyping tool for electrical load emulation using power electronic converters" Industrial Electronics & Applications, 2009, ISBM: 978-1-4244-4681-0.

### Summary of the Invention

According to the present invention from one aspect, there is provided a method of simulating a transmission line, the method comprising using a programmed processing unit to condition an input electrical signal for producing an output signal characteristic of a signal which has passed through such a transmission line, characterised in that said output signal is characteristic of a communication on power signal which has passed through a transmission line comprising an umbilical cable for use with a subsea fluid extraction well.

According to the present invention from another aspect, there is provided a method of testing control equipment for a subsea fluid extraction well, the method comprising simulating an umbilical cable using a programmed processing unit to condition an input electrical signal for producing an output signal characteristic of a signal which has passed through such an umbilical cable and supplying that output signal to the control equipment, said output signal being characteristic of a communication on power signal which has passed through such an umbilical cable

In each such method the input electrical signal may be DC and the DC input electrical signal is conditioned by a DC-AC converter. The converter may condition the input electrical signal using pulse width modulation. The DC-AC converter may comprise an H-bridge, and for example comprises a plurality of switches, the operation timings of the switches being controlled by the programmed processing unit to effect the conditioning.

According to the present invention from a further aspect, there is provided apparatus for simulating a transmission line, the apparatus comprising a processing unit which has been programmed for conditioning an input electrical signal for producing an output signal characteristic of a signal which has passed through such a transmission line, characterised in that said unit is programmed so that said output signal is characteristic of a communication on power signal which has passed through a transmission line comprising an umbilical cable for use with a subsea fluid extraction well.

Such apparatus could comprise a DC-AC converter for conditioning the input electrical signal. The converter may condition the input electrical signal using pulse width modulation. The DC-AC converter may comprise an H-bridge, and for example comprises a plurality of switches, the operation timings of the switches being controlled by the programmed processing unit to effect the conditioning.

The present invention enables the design of a novel generic or universal programmable umbilical simulator which can be easily adapted for use in testing all subsea control equipment. This is achieved by including a programmable processing unit in a simulator so that only the software need be adapted to change the characteristics of the simulator as required.

### Brief Description of the Drawings

Fig. 1 is a schematic diagram of a typical subsea fluid extraction well control system;
Fig. 2 is a schematic diagram of an embodiment of a simulator according to the invention; and
Fig. 3 is a schematic diagram of components of the simulator of Fig.2 in more detail.

### Description of an Embodiment of the Invention.

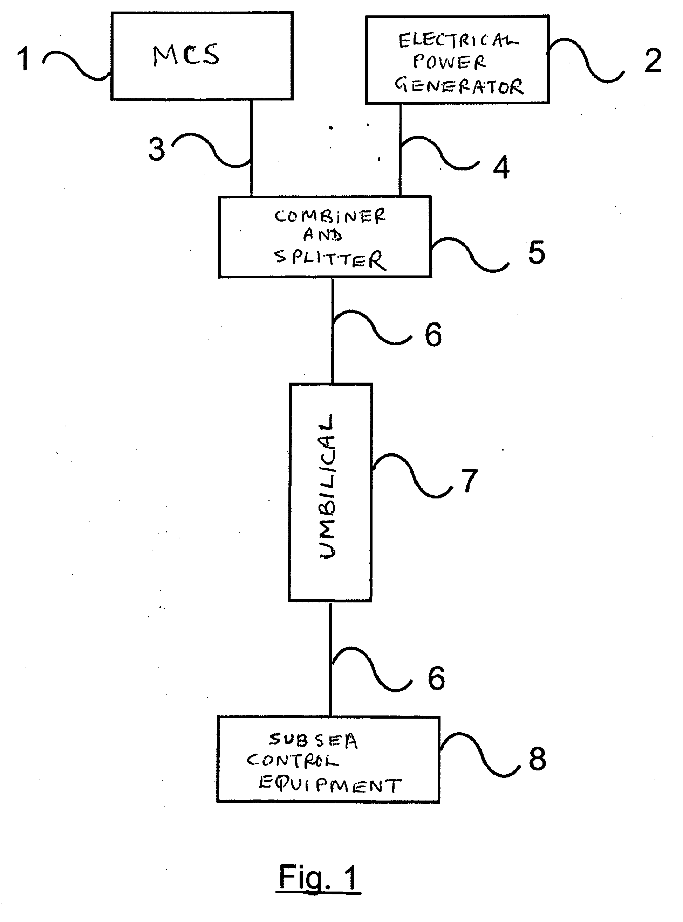

The configuration of a typical subsea fluid extraction well control system is shown in Figure 1. A master control station (MCS) 1, situated on a floating platform or rig, enables an operator to control the operation of an offshore well. An electrical power generator 2, which is usually co-located with the station 1, provides all the electrical power supply required by subsea control equipment 8 which is positioned subsea. The electrical power supply on a line 4 is passed to combiner and splitter equipment 5, where communication signals on line 3 from the master control station (i.e. control signals to the subsea control equipment) are combined with the electrical power supply. The combined electrical power and communication signals on a line 6 are then transmitted via an umbilical cable to the subsea control equipment 8. Also, return sensor signals from the subsea control equipment on line 6 are split off by the splitter 5 and received by station 1 via line 3.

The umbilical cable 7 exhibits the characteristics of an electrical transmission line at both the operating frequency of the electrical power supply and that of the communications, such as signal attenuation, loss of power along its length and reflections due to load mismatch.

Such characteristics of the umbilical cable may be determined either theoretically, or from practical experience. In particular, the physical dimensions and quantities of copper to be used are known, and hence the impedance per unit length of the umbilical cable, for various frequencies, may also be determined. In addition, experienced well operators also have data on how signals of various frequencies are affected by umbilical cables of various dimensions.

The programmable umbilical cable simulator to be described is a single device that can be programmed to simulate the electrical behaviour of any umbilical cable, and can be used for any subsea system and is intended to replace the present variety of umbilical cable simulators with a single programmable one.

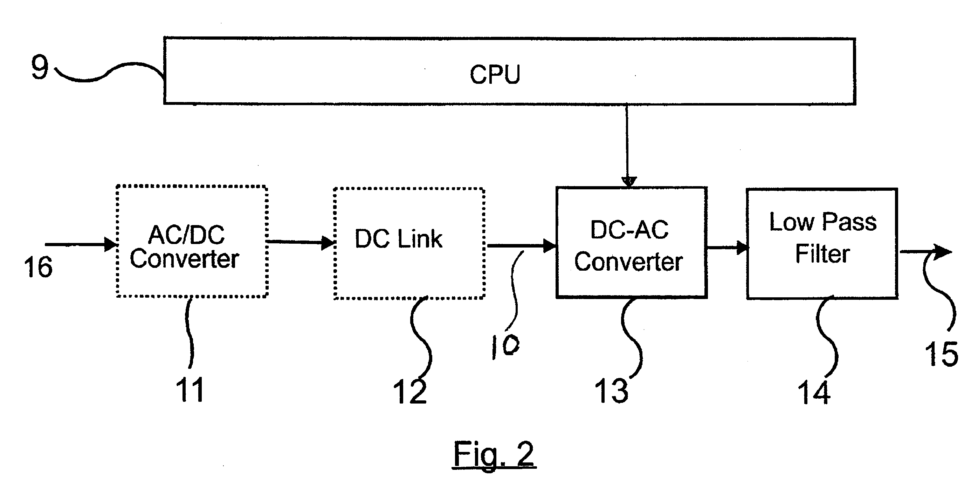

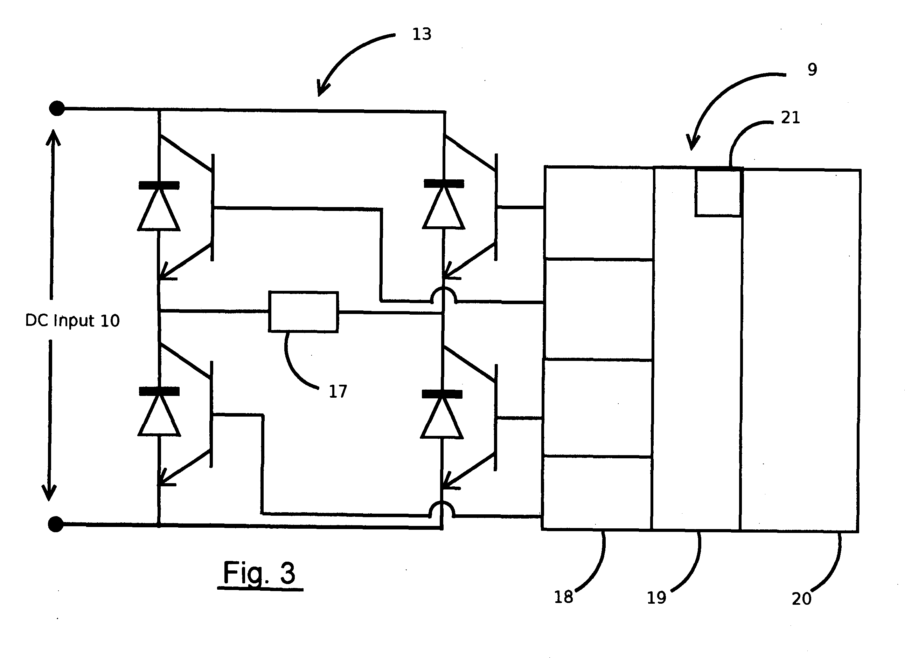

The configuration of the programmable umbilical cable simulator is shown in Fig. 2. The apparatus comprises a programmable central processing unit (CPU) 9 coupled to a DC to AC converter (i.e. an inverter) 13 which receives an input DC electrical signal at an input 10. Fig. 3 shows these two components in greater detail. The converter 13 (in the form of a so-called H-bridge shown in more detail in Fig. 3 and described in more depth below) converts the DC to AC using digitally controlled pulse width modulation (PWM) techniques to produce a power waveform which is acted on by CPU 9. More particularly, the CPU 9 has been programmed so that it distorts the waveform produced by converter 13 so that appropriate harmonic content is added to the power waveform so that the output from converter 13 is a simulation of the output of a particular umbilical cable So that the simulation is one of a COP signal from the umbilical cable, the CPU 9 is programmed so that suitable information is also added to or imprinted on the power waveform to achieve that. A signal input 16 is provided for receiving an input signal, for example a "pure" sinusoidal waveform.

The above simulator would be used at a test facility for testing subsea control equipment, the output from converter 13 being supplied to the equipment to be tested via an output 15, if necessary via an optional low pass filter 14.

If only AC electrical power is available at the test facility, the simulator may include an AC/DC converter 11 and a DC link 12 between input 16 and input 10 to provide the DC input power required by the DC-AC converter 13.

In either case, the simulator may be provided as a piece of hardware, with an input 16, output 15, and means, for example a human interaction interface such as a keyboard, monitor etc (not shown), for instructing the CPU 9 to provide the desired simulation. Alternatively, the simulator may be connected to separate computing means, for example via universal serial bus (USB) connection or the like.

Fig. 3 shows the CPU 9 and DC-AC converter 13 in more detail. The converter 13 comprises a standard H-bridge, with a switch on each arm of the "H" comprising a transistor and operable on DC input 10. For convenience, the output from converter 13 is shown as a simple load 17. Each switch is driven by a driver 18 of the CPU 9, the drivers 18 being controlled by processing means 19. Processing means 19 is operable to obtain information from a database 20, which stores look-up tables containing frequency-dependent pulse width modulation (PWM) timings. A read / write unit 21 is provided enabling operators to interact with the CPU 9, for example to update or modify the information stored in database 20, or to input the desired umbilical cable physical characteristics. This may comprise human-interface means as described above, or may enable connection to an external computing means.

### Operation

For the purposes of illustration, the following description of the simulator operation will be described where a standard COP system using an AC input for a subsea installation is required to be tested.

Initially, the database 20 of CPU 9 is loaded with look-up tables providing PWM timings for a set of possible umbilical cable physical characteristics. Since the umbilical cable will affect different frequency signals in different ways, the look-up tables are frequency-dependent. This step will typically carried out once only, during initial set-up of the simulator, unless, for example, errors are found at a later stage. The look-up tables are concatenated, so that a single PWM timing sequence may be derived for the frequencies of interest, i.e. the COP frequencies.

The subsea equipment to be tested is connected to output 15 of the simulator, and a signal source is connected to AC input 16, the source being equivalent to that which would be supplied in use of the subsea equipment. Generally, the signal source will be relatively "pure", i.e. a superposition of sinusoidal signals of various frequencies with little distortion, although since with the COP system there is a relatively complex superposition of frequencies, i.e. a number of different frequency inputs are used, the input may not appear particularly pure.

The characteristics of the umbilical cable to be used are entered into CPU 9 via unit 21, and the processing means 19 selects the corresponding look-up tables in database 20 and retrieves the relevant PWM switch timings. Processing means 19 then controls drivers 18 to operate each switch of the converter 13 at the correct PWM switch timing.

The AC input is converted to DC by AC/DC converter 11, and passed via link 12 to input 10 of converter 13.
The converter 13 then converts the input DC signal 10 to AC, however harmonics will be introduced into that AC signal by virtue of the switch timings used by the converter 13. In other words, the signal will become distorted, in a similar manner as would occur using an umbilical cable of the physical characteristics specified.
The AC output from the converter 13 is passed through a low pass filter 14 if required, and then output via output 15 to the test equipment.

### Advantages of using the Invention

Some advantages of a programmable umbilical cable simulator according to the invention are set out below.

More comprehensive testing of systems can be carried out as a programmable simulator enables a wider range of umbilical cable characteristics and different system possibilities to be simulated for a single test configuration.

Having to design, develop, and build an umbilical cable simulator for each subsea control equipment to be tested is time consuming, uses manpower and is expensive. The use of a generic simulator will significantly reduce these costs. This is because the changes required are limited to the software content, the hardware design requiring no modifications.

The programmable umbilical cable simulator is a product in its own right as it can be supplied as a test tool forming part of the test equipment supplied to a customer for testing and maintenance or as a separate product.

## Claims

1. A method of simulating a transmission line, the method comprising using a programmed processing unit (9) to condition an input electrical signal for producing an output signal characteristic of a signal which has passed through such a transmission line, **characterised in that** said output signal is characteristic of a communication on power signal which has passed through a transmission line comprising an umbilical cable for use with a subsea fluid extraction well.

2. A method according to claim 1, wherein the input electrical signal is DC and the DC input electrical signal is conditioned by a DC-AC converter (13).

3. A method according to claim 2, wherein the converter (13) conditions the input electrical signal using pulse width modulation.

4. A method according to either of claims 2 and 3, wherein the DC-AC converter (13) comprises an H-bridge.

5. A method according to claim 4, wherein the H-bridge (13) comprises a plurality of switches, the operation timings of the switches being controlled by the programmed processing unit (9) to effect the conditioning.

6. A method of testing control equipment for a subsea fluid extraction well, the method comprising simulating an umbilical cable using a programmed processing unit (9) to condition an input electrical signal for producing an output signal characteristic of a signal which has passed through such an umbilical cable and supplying that output signal to the control equipment, said output signal being characteristic of a communication on power signal which has passed through such an umbilical cable.

7. A method according to claim 6, wherein the input electrical signal is DC, and the DC input electrical signal is conditioned by a DC-AC converter (13).

8. A method according to claim 7, wherein the converter (13) conditions the input electrical signal using pulse width modulation.

9. A method according to either of claims 7 and 8, wherein the DC-AC converter (13) comprises an H-bridge.

10. A method according to claim 9, wherein the H-bridge (13) comprises a plurality of switches, the operation timings of the switches being controlled by the programmed processing unit (9) to effect the conditioning.

11. Apparatus for simulating a transmission line, the apparatus comprising a processing unit (9) which has been programmed for conditioning an input electrical signal for producing an output signal characteristic of a signal which has passed through such a transmission line, **characterised in that** said unit is programmed so that said output signal is characteristic of a communication on power signal which has passed through a transmission line comprising an umbilical cable for use with a subsea fluid extraction well.

12. Apparatus according to claim 11, comprising a DC-AC converter (13) for conditioning the input electrical signal.

13. Apparatus according to claim 12, wherein the converter (13) conditions the input electrical signal using pulse width modulation.

14. Apparatus according to either of claims 12 and 13, wherein the DC-AC converter (13) comprises an H-bridge.

15. Apparatus according to claim 14, wherein the H-bridge (13) comprises a plurality of switches, the operation timings of the switches being controlled by the programmed processing unit to effect the conditioning.

## Patentansprüche

1. Verfahren zum Simulieren einer Übertragungsleitung, wobei das Verfahren die Verwendung einer programmierten Verarbeitungseinheit (9) umfasst, um ein elektrisches Eingangssignal aufzubereiten, um ein Ausgangssignal zu erzeugen, das für ein Signal charakteristisch ist, das durch eine derartige Übertragungsleitung gelaufen ist, **dadurch gekennzeichnet, dass** das Ausgangssignal für ein Communication-on-Power-Signal charakteristisch ist, das durch eine Übertragungsleitung gelaufen ist, die eine Kabelverbindung für die Verwendung mit einem Untersee-Fluidextraktionsbrunnen umfasst.

2. Verfahren nach Anspruch 1, wobei das elektrische Eingangssignal ein Gleichstromsignal ist und das elektrische Gleichstrom-Eingangssignal von einem Gleichstrom-Wechselstrom-Wandler (13) aufbereitet wird.

3. Verfahren nach Anspruch 2, wobei der Wandler (13) das elektrische Eingangssignal unter Verwendung von Pulsweitenmodulation aufbereitet.

4. Verfahren nach einem der Ansprüche 2 und 3, wobei der Gleichstrom-Wechselstrom-Wandler (13) eine H-Brücke umfasst.

5. Verfahren nach Anspruch 4, wobei die H-Brücke (13) mehrere Schalter umfasst, wobei die Betriebszeiten der Schalter von der programmierten Verarbeitungseinheit (9) gesteuert werden, um die Aufbereitung zu bewirken.

6. Verfahren zum Prüfen von Steuerausrüstung für einen Untersee-Fluidextraktionsbrunnen, wobei das Verfahren Folgendes umfasst: Simulieren einer Kabelverbindung unter Verwendung einer programmierten Verarbeitungseinheit (9) zum Aufbereiten eines elektrischen Eingangssignals zum Erzeugen eines Ausgangssignals, das für ein Signal charakteristisch ist, das durch eine derartige Kabelverbindung gelaufen ist, und Zuführen dieses Ausgangssignals zu der Steuerausrüstung, wobei das Ausgangssignal für ein Communication-on-Power-Signal charakteristisch ist, das durch eine derartige Kabelverbindung gelaufen ist.

7. Verfahren nach Anspruch 6, wobei das elektrische Eingangssignal ein Gleichstromsignal ist und das elektrische Gleichstrom-Eingangssignal von einem Gleichstrom-Wechselstrom-Wandler (13) aufbereitet wird.

8. Verfahren nach Anspruch 7, wobei der Wandler (13) das elektrische Eingangssignal unter Verwendung von Pulsweitenmodulation aufbereitet.

9. Verfahren nach einem der Ansprüche 7 und 8, wobei der Gleichstrom-Wechselstrom-Wandler (13) eine H-Brücke umfasst.

10. Verfahren nach Anspruch 9, wobei die H-Brücke (13) mehrere Schalter umfasst, wobei die Betriebszeiten der Schalter von der programmierten Verarbeitungseinheit (9) gesteuert werden, um die Aufbereitung zu bewirken.

11. Vorrichtung zum Simulieren einer Übertragungsleitung, wobei die Vorrichtung eine Verarbeitungseinheit (9) umfasst, die dazu programmiert wurde, ein elektrisches Eingangssignal aufzubereiten, um ein Ausgangssignal zu erzeugen, das für ein Signal charakteristisch ist, das durch eine derartige Übertragungsleitung gelaufen ist, **dadurch gekennzeichnet, dass** die Einheit derart programmiert ist, dass das Ausgangssignal für ein Communication-on-Power-Signal charakteristisch ist, das durch eine Übertragungsleitung gelaufen ist, die eine Kabelverbindung für die Verwendung mit einem Untersee-Fluidextraktionsbrunnen umfasst.

12. Vorrichtung nach Anspruch 11, umfassend einen Gleichstrom-Wechselstrom-Wandler (13) zum Aufbereiten des elektrischen Eingangssignals.

13. Vorrichtung nach Anspruch 12, wobei der Wandler (13) das elektrische Eingangssignal unter Verwendung von Pulsweitenmodulation aufbereitet.

14. Vorrichtung nach einem der Ansprüche 12 und 13, wobei der Gleichstrom-Wechselstrom-Wandler (13) eine H-Brücke umfasst.

15. Vorrichtung nach Anspruch 14, wobei die H-Brücke (13) mehrere Schalter umfasst, wobei die Betriebszeiten der Schalter von der programmierten Verarbeitungseinheit gesteuert werden, um die Aufbereitung zu bewirken.

## Revendications

1. Procédé de simulation d'une ligne de transmission, le procédé comprenant l'utilisation d'une unité de traitement programmée (9) pour conditionner un signal électrique d'entrée afin de produire un signal de sortie qui est caractéristique d'un signal qui est passé par une telle ligne de transmission, **caractérisé en ce que** ledit signal de sortie est caractéristique d'un signal de communications sur alimentation qui est passé par une ligne de transmission comprenant un câble ombilical destiné à être utilisé avec un puits d'extraction de fluide sous-marin.

2. Procédé selon la revendication 1, dans lequel le signal électrique d'entrée est C.C. et le signal électrique d'entrée C.C. est conditionné par un convertisseur C.C.-C.A. (13).

3. Procédé selon la revendication 2, dans lequel le convertisseur (13) conditionne le signal électrique d'entrée par modulation de largeur d'impulsion.

4. Procédé selon la revendication 2 ou la revendication 3, dans lequel le convertisseur C.C.-C.A. (13) comprend un pont H.

5. Procédé selon la revendication 4, dans lequel le pont H (13) comprend une pluralité de commutateurs, les cadencements de fonctionnement des commutateurs étant commandés par l'unité de traitement programmée (9) pour effectuer le conditionnement.

6. Procédé de test d'un équipement de commande d'un puits d'extraction de fluide sous-marin, le procédé comprenant la simulation d'un câble ombilical utilisant une unité de traitement programmée (9) pour conditionner un signal électrique d'entrée afin de produire un signal de sortie qui est caractéristique d'un signal qui est passé par un tel câble ombilical et la fourniture de ce signal de sortie à l'équipement de commande, ledit signal de sortie étant caractéristique d'un signal de communications sur alimentation qui est passé par un tel câble ombilical.

7. Procédé selon la revendication 6, dans lequel le signal électrique d'entrée est C.C., et le signal électrique d'entrée est conditionné par un convertisseur C.C.-C.A. (13).

8. Procédé selon la revendication 7, dans lequel le convertisseur (13) conditionne le signal électrique d'entrée par modulation de largeur d'impulsion.

9. Procédé selon la revendication 7 ou la revendication 8, dans lequel le convertisseur C.C.-C.A. (13) comprend un pont H.

10. Procédé selon la revendication 9, dans lequel le pont H (13) comprend une pluralité de commutateurs, les cadencements de fonctionnement des commutateurs étant commandés par l'unité de traitement programmée (9) pour effectuer le conditionnement.

11. Procédé de simulation d'une ligne de transmission, l'appareil comprenant une unité de traitement (9) qui a été programmée pour conditionner un signal électrique d'entrée afin de produire un signal de sortie qui est caractéristique d'un signal qui est passé par une telle ligne de transmission, **caractérisé en ce que** ladite unité est programmée de telle sorte que ledit signal de sortie soit caractéristique d'un signal de communications sur alimentation qui est passé par une ligne de transmission comprenant un câble ombilical destiné à être utilisé avec un puits d'extraction de fluide sous-marin.

12. Appareil selon la revendication 11, comprenant un convertisseur C.C.-C.A. (13) pour conditionner le signal électrique d'entrée.

13. Appareil selon la revendication 12, dans lequel le convertisseur (13) conditionne le signal électrique d'entrée par modulation de largeur d'impulsion.

14. Appareil selon la revendication 12 ou la revendication 13, dans lequel le convertisseur C.C.-C.A. (13) comprend un pont H.

15. Appareil selon la revendication 14, dans lequel le pont H (13) comprend une pluralité de commutateurs, les cadencements de fonctionnement des commutateurs étant commandés par l'unité de traitement programmée pour effectuer le conditionnement.
